Europäisches Patentamt

European Patent Office

Office européen des brevets

(11) Veröffentlichungsnummer: **0 250 620**
**B1**

(12) **EUROPÄISCHE PATENTSCHRIFT**

(45) Veröffentlichungstag der Patentschrift:
05.09.90

(21) Anmeldenummer: 86108680.9

(22) Anmeldetag: 25.06.86

(51) Int. Cl.⁵: **G01R 31/28,** G01R 1/073

(54) Verfahren und Vorrichtung zum elektrischen Prüfen von Leiterplatten.

(43) Veröffentlichungstag der Anmeldung:
07.01.88 Patentblatt 88/1

(45) Bekanntmachung des Hinweises auf die Patenterteilung:
05.09.90 Patentblatt 90/36

(84) Benannte Vertragsstaaten:
AT BE CH DE FR GB IT LI LU NL SE

(56) Entgegenhaltungen:
DE-A- 2 013 070
DE-A- 2 707 900
DE-A- 3 524 229
US-A- 4 321 533
US-A- 4 471 298

(73) Patentinhaber: MANIA Elektronik Automatisation Entwicklung und Gerätebau GmbH, Technologiepark, D-6395 Wellrod 8(DE)

(72) Erfinder: Driller, Hubert, Dipl.-Phys., Altkönigstrasse 11, D-6384 Schmitten 3(DE)
Erfinder: Mang, Paul, Weilbergstrasse 4, D-6384 Schmitten 3(DE)

(74) Vertreter: Ruschke, Hans Edvard et al, Patentanwälte Dipl.-Ing. Olaf Ruschke Dipl.-Ing. Hans E. Ruschke Dipl.-Ing. Jürgen Rost Dipl.-Chem. Dr. U. Rotter Pienzenauerstrasse 2, D-8000 München 80(DE)

## Beschreibung

Die Erfindung betrifft ein Verfahren zum elektrischen Prüfen von Verdrahtungsträgern, wie Leiterplatten, Keramik-Leiterplatten, gedruckten Schaltungen und flexiblen Schaltungen nach dem Oberbegriff des Patentanspruches 1 und Vorrichtungen zur Durchführung dieses Verfahrens nach den Oberbegriffen der Patentansprüche 6, 10, 12 und 14.

Beim elektrischen Prüfen von Leiterplatten sollen folgende Prüfungen durchgeführt werden. Es soll erstens die Leitfähigkeit der auf einer Leiterplatte enthaltenen Netzwerke bzw. Leiterbahnen, und zwar von jedem Anschlußpunkt zu jedem Anschlußpunkt, geprüft werden. Zweitens sollen die Isolationswiderstände, die zwischen den einzelnen Netzwerken bzw. Leiterbahnen der Leiterplatte bestehen, möglichst genau gemessen werden. Anders ausgedrückt soll im Rahmen der Meßmöglichkeiten der vorhandenen Elektronik ein möglichst hoher Isolationswiderstand gemessen werden.

Üblicherweise werden derartige Prüfungen an Leiterplatten dadurch vorgenommen, daß über eine Adaptiervorrichtung, wie sie beispielsweise in der DE-A 2 707 900 beschrieben ist, elektrische Verbindungen zwischen den Anschlußpunkten der Leiterplatten und den Kontaktpunkten eines Rasterkontaktfeldes selektiv über elektronische Schalter ansteuerbar ist. Als elektronische Schalter dienen vorzugsweise Transistoren, beispielsweise MOS-Feldeffekttransistoren.

Ein Problem besteht dabei jedoch darin, daß derartige Transistoren keine idealen Schalter sind, die entweder einen unendlichen Widerstand oder einen Null-Widerstand besitzen. Vielmehr weisen sie einen relativ kleinen Einschaltwiderstand, der von Null verschieden ist, und einen relativ hohen Ausschaltwiderstand auf, der nicht dem Wert "Unendlich" entspricht. Dies hat aber zur Folge, daß bei der Messung des Isolationswiderstandes zwischen einer bestimmten Leiterbahn und anderen Leiterbahnen einer Leiterplatte alle Leckströme mitgemessen werden, die den mit den Anschlußpunkten der bestimmten Leiterbahn verbundenen Transistoren zuzuschreiben sind, da alle diese Transistoren zu der bestimmten Leiterbahn – zwischen der bestimmten Leiterbahn und Ground – parallel geschaltet sind. Die Addition dieser Leckströme fällt dann nicht störend ins Gewicht, wenn die bestimmten Leiterbahnen relativ kurz sind. Je länger Leiterbahnen sind, desto störender gehen jedoch diese Leckströme in das Meßergebnis ein. Während typischerweise bei Leiterplatten die Hälfte bis zwei Drittel der gesamten Anschlußpunkte auf sehr viele Leiterbahnen einer relativ kurzen Länge verteilt sind, ist der Rest der Anschlußpunkte auf die Spannungsversorgung und die Taktzuleitung betreffende Leiterbahnen verteilt. Da derartige Leiterbahnen naturgemäß sehr lang sind und daher viele Anschlußpunkte aufweisen, ergeben sich infolge der Leckströme der mit diesen Anschlußpunkten verbundenen Transistoren beim Messen der Isolation zwischen diesen Leiterbahnen und anderen Leiterbahnen erhebliche Probleme. In der Realität befinden sich zum Beispiel etwa 30% der gesamten Anschlußpunkte einer Leiterplatte auf der "Ground" führenden Leiterbahn, während sich etwa 15% der Anschlußpunkte auf der die Versorgungsspannung $V_{CC}$ führenden Leiterbahn befinden. Dies liegt unter anderem daran, daß die Eingänge sehr vieler Bausteine an Masse gelegt werden, wenn sie nicht benutzt werden.

Aus den obigen Ausführungen ergibt sich, daß dann, wenn der Isolationswiderstand zwischen der "Ground" führenden Leiterbahn und irgendeiner anderen Leiterbahn einer Leiterplatte gemessen werden soll, u.U. bis zu 15.000 gesperrte Transistoren parallel geschaltet sind. Dies bedeutet, daß sich die Leckströme dieser 15.000 Transistoren addieren und in das Meßergebnis eingehen.

Es ist ein Verfahren bekannt, bei dem eine Software-Leckstromkorrektur vorgenommen wird. Zu diesem Zweck mißt man die Leckströme der Transistoren eines guten Musters bei der Programmierung. Die derart jeweils ermittelten Leckströme werden dann bei den eigentlichen Messungen jeweils als Korrekturwerte benutzt. Ein Nachteil eines derartigen Korrekturverfahrens besteht jedoch darin, daß es in einem gewissen Maße fehlerhaft ist, so daß die Meßgenauigkeit bei der genannten möglichen großen Anzahl von z.B. 15.000 parallel geschalteten Transistoren sehr klein ist. Selbst wenn man von einem kleinen Korrekturfehler von 1% ausgeht, geht bei der genannten Transistorenzahl in die Messung immer noch der Leckstrom von 150 Transistoren ein. Zudem kann bei einer derartigen Software-Korrektur einer unterschiedlichen Temperaturverteilung im Gerät, die zu bereichsweise unterschiedlichen Leckströmen führt, nicht Rechnung getragen werden.

Die Aufgabe der vorliegenden Erfindung besteht daher darin, ein Verfahren zum elektrischen Prüfen von Leiterplatten anzugeben, durch das eine genaue Messung des Isolationswiderstandes zwischen einer relativ langen Leiterbahn und anderen Leiterbahnen einer Leiterplatte ermöglicht wird.

Außerdem sollen durch die vorliegende Erfindung Vorrichtungen zur Durchführung dieses Verfahrens geschaffen werden.

Diese Aufgabe wird durch ein wie eingangs bereits erwähntes Verfahren, das durch die in dem kennzeichnenden Teil des Patentanspruches 1 angegebenen Merkmale gekennzeichnet ist, und durch Vorrichtungen gelöst, die durch die in den kennzeichnenden Teilen der Patentansprüche 6, 10, 12 und 14 jeweils angegebenen Merkmale gekennzeichnet sind.

Ein wesentlicher Vorteil des erfindungsgemäßen Verfahrens besteht darin, daß der Isolationswiderstand zwischen verhältnismäßig langen Leiterbahnen und anderen Leiterbahnen einer Leiterplatte in einer relativ einfachen und unkomplizierten Weise unter Ausführung nur eines einfachen Zusatzschrittes nach der Messung der Leitfähigkeit der Leiterbahnen meßbar ist. Dabei können die Isolationsmessungen vorteilhafterweise mit einer größtmöglichen Empfindlichkeit ausgeführt werden.

Vorteilhafterweise sind die Vorrichtungen zur Durchführung des erfindungsgemäßen Verfahrens einfach aufgebaut und leicht handhabbar.

Besonders vorteilhaft ist eine Weiterbildung des erfindungsgemäßen Verfahrens, gemäß der zwischen die der Leiterplatte zugewandten Enden der Prüfstifte der Adaptiervorrichtung und die Leiterplatte eine Maske eingebracht und derart ausgerichtet wird, daß pro Leiterbahn ein Prüfstift durch eine Öffnung der Maske hindurchragt, um eine elektrische Verbindung zwischen dem jeweils einen Anschlußpunkt der Leiterbahn und dem ersten und zweiten elektronischen Schalter herzustellen. Insbesondere ist die Herstellung einer derartigen Maske vorteilhafterweise verhältnismäßig einfach. Dabei weist die Maske in einer besonders vorteilhaften Ausgestaltung die Form einer dünnen isolierenden Platte mit Öffnungen auf. Eine derartige Platte weist bei einem möglichen Federweg der Kontaktelemente des Rasterfeldes von 2 bis 6 mm vorzugs.weise eine Dicke von etwa 0,2 mm auf. Besonders einfach ist die Handhabung der Maske, wenn Justiereinrichtungen vorgesehen werden, durch die die Maske vor Ausführung der anderen Verfahrensschritte in einer zur Leiterbahn ausgerichteten Position bringbar ist.

Bei einer anderen bevorzugten Weiterbildung des erfindungsgemäßen Verfahrens weist die Adaptiervorrichtung Prüfstifte unterschiedlicher Länge auf, wobei der Längenunterschied zwischen den Prüfstifte so bemessen ist, daß er kleiner ist als der Federweg der Kontaktelemente eines Kontaktfeldes, in die die der Leiterplatte abgewandten Enden der Prüfstifte zur Herstellung der elektrischen Verbindungen mit den ersten und zweiten elektronischen Schaltern eingreifen. Bei den einen Verfahrensschritten werden dabei über alle Prüfstifte elektrische Verbindungen zwischen den Anschlußpunkten der Leiterplatte und entsprechenden Kontaktelementen des Kontaktfeldes hergestellt. Vor den anderen Verfahrensschritten wird die Leiterplatte dann unter Beibehaltung ihrer ausgerichteten Position derart angehoben, daß die elektrischen Verbindungen zwischen den kurzen Prüfstiften und den ihnen zugeordneten Anschlußpunkten der Leiterbahnen unterbrochen werden, und daß über jeweils einen langen Prüfstift pro Leiterbahn eine elektrische Verbindung zwischen dem jeweils einen Anschlußpunkt der Leiterbahn und dem entsprechenden Kontaktelement des Kontaktfeldes bestehen bleibt. Ein derartiges Verfahren ist besonders vorteilhaft, weil keine zusätzlichen Ausrichtschritte erforderlich sind. Die Adaptiervorrichtung zur Durchführung dieser Weiterbildung des vorliegenden Verfahrens weist kurze und längere Prüfstifte auf, wobei jeweils ein längerer Prüfstift so angeordnet ist, daß er einem bestimmten Anschlußpunkt einer Leiterbahn der Leiterplatte zugeordnet ist und wobei der Längenunterschied zwischen den kurzen und langen Prüfstiften kleiner ist als der mögliche Federweg der Kontaktelemente des der Adaptiervorrichtung zugeordneten Rasterfeldes. Besonders bevorzugt ist eine Adaptiervorrichtung, bei der der Längenunterschied zwischen den kurzen und längeren Prüfstiften bei einem möglichen Federweg der Kontaktelemente von etwa 4 bis 8 mm in einem Bereich von etwa 2 bis 3 mm liegt.

Bei einer weiteren bevorzugten Weiterbildung des erfindungsgemäßen Verfahrens wird eine Adaptiervorrichtung verwendet, die federnde Prüfstifte mit unterschiedlichen Federwegen aufweist. Dabei werden bei den einen Verfahrensschritten über alle Prüfstifte elektrische Verbindungen zwischen den Anschlußpunkten der Leiterplatte und entsprechenden Kontaktelementen eines Kontaktfeldes in die die der Leiterplatte abgewandten Enden der Prüfstifte zur Herstellung der elektrischen Verbindungen mit den ersten und zweiten elektronischen Schaltern eingreifen, hergestellt. Vor den anderen Verfahrensschritten wird die Leiterplatte unter Beibehaltung ihrer ausgerichteten Position derart angehoben, daß die elektrischen Verbindungen zwischen den Prüfstiften mit den kurzen Federwegen und den ihnen zugeordneten Anschlußpunkten der Leiterbahnen unterbrochen werden und daß über jeweils einen Prüfstift mit einem langen Federweg pro Leiterbahn eine elektrische Verbindung zwischen dem jeweils einen Anschlußpunkt der Leiterbahn und dem entsprechenden Kontaktelement des Kontaktfeldes bestehen bleibt. Bei dieser Weiterbildung des erfindungsgemäßen Verfahren sind vorteilhafterweise ebenfalls keine Ausrichtoperationen erforderlich. Die im Zusammenhang mit dieser Weiterbildung des erfindungsgemäßen Verfahrens verwendete Adaptiervorrichtung weist in Längsrichtung federnde Prüfstifte mit kürzeren Federwegen und in Längsrichtung federnde Prüfstifte mit längeren Federwegen auf, wobei jeweils ein Prüfstift mit einem längeren Federweg so angeordnet ist, daß er einem bestimmten Anschlußpunkt einer Leiterbahn der Leiterplatte zugeordnet ist.

Bei den voranstehend beschriebenen beiden bevorzugten Weiterbildungen wird zur Vereinfachung einer exakten Verschiebung der Leiterplatte vorzugsweise eine Verschiebeeinrichtung vorgesehen, die dafür Sorge trägt, daß die Leiterplatte unter Beibehaltung ihrer zu den Prüfstiften ausgerichteten Position in der Längsrichtung der Prüfstifte um eine vorgegebene Strecke bewegbar ist.

Bei einer weiteren bevorzugten Weiterbildung des erfindungsgemäßen Verfahrens wird vor Ausführung der anderen Verfahrensschritte zwischen die dem Kontaktfeld zugewandten Enden der Prüfstifte und die Kontaktelemente des Kontaktfeldes ein rastergebundenes Zwischenkontaktfeld eingebracht und derart ausgerichtet, daß pro Leiterbahn ein Prüfstift über ein starres Kontaktglied des Zwischenkontaktfeldes eine elektrische Verbindung zwischen dem jeweils einen Anschlußpunkt der Leiterbahn und dem entsprechenden Kontaktelement herstellt, das dem ersten und zweiten elektronischen Schalter vorgeschaltet ist. Ein Vorteil dieser Weiterbildung besteht darin, daß ein derartiges Zwischenkontaktfeld verhältnismäßig einfach aufgebaut sein kann und automatisch mit den Kontaktgliedern relativ einfach bestückt werden kann, weil die Orte, an denen diese Kontaktglieder selektiv anzuordnen sind, in Koordinaten sehr leicht angegeben werden können. Das rastergebundene Zwischenkontaktfeld weist vorzugsweise an den einzelnen Rasterpunkten Durchgangslöcher auf, in die selektiv starre Kontaktglieder zur Herstellung der elektrischen Verbindungen einsetzbar sind. In einer besonders einfachen und bevorzugten Form besteht das Zwischenkontaktfeld aus einer isolierenden Platte, in deren Durchgangslöcher selektiv stiftähnliche Elemente als Kontaktglieder einsetzbar sind. Besonders einfach sind derartige stiftähnliche Kontaktglieder handhabbar, wenn sie über ihren Umfang hinausragende Ansätze aufweisen, die als Anschläge dienen und die Einschubbewegung von einer Seite des Zwischenkontaktfeldes her beenden.

Im folgenden werden die Erfindung und deren Ausgestaltungen im Zusammenhang mit den Figuren näher erläutert. Es zeigt:

Fig. 1 in schematischer Weise eine über eine bekannte Adaptiervorrichtung mit einem Rasterfeld elektrisch verbundene Leiterplatte;

Fig. 2 eine Darstellung zur Erläuterung der Messung der Leitfähigkeit und der Messung des Isolationswiderstandes zwischen Leiterbahnen; und

Fig. 3, 4a, 4b, 5a, 5b, 6 und 7 in schematische Darstellung Vorrichtungen zur Durchführung des erfindungsgemäßen Verfahrens.

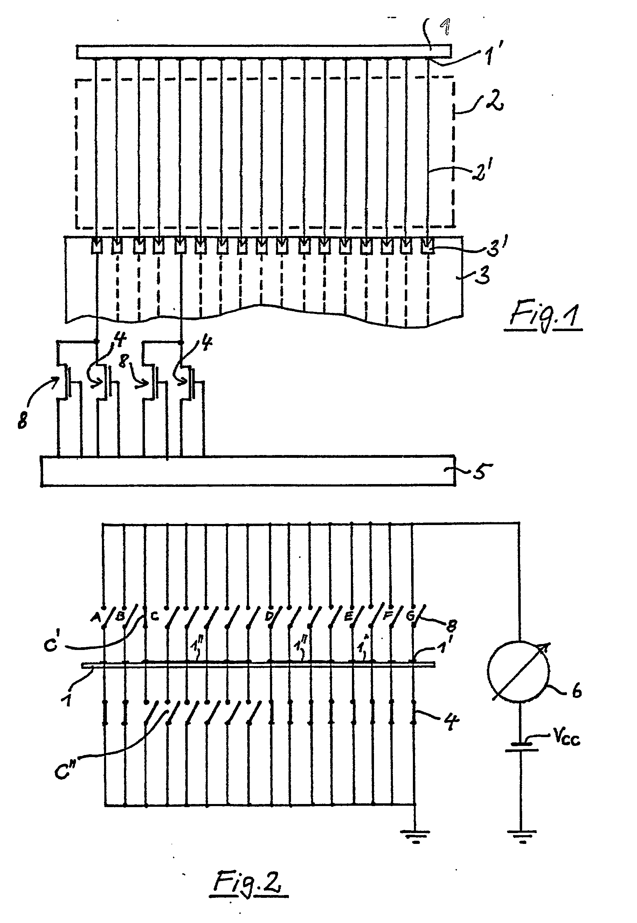

In der Fig. 1 ist eine zu prüfende Leiterplatte mit 1 bezeichnet. Diese Leiterplatte 1 weist Durchkontaktierungen bzw. Anschlußpunkte 1' auf, die in an sich bekannter Weise dadurch mit den ihnen zugewandten Spitzen von Prüfstiften 2, einer Adaptiervorrichtung 2 in Kontakt gebracht werden, daß die Leiterplatte 1, nachdem sie in die richtige Position gebracht wurde, gegen die Spitzen der Prüfstifte 2' gedrückt wird. An der anderen Seite der Adaptiervorrichtung 2 ist ein Rasterfeld 3 angeordnet, das beispielsweise federnde Kontaktelemente 3' aufweist, in die die der Leiterplatte 1 abgewandten Spitzen bzw. Enden der Prüfstifte 2' eingreifen. Jedes Kontaktelement 3' ist mit einem elektronischen Schalter 4, 8 verbunden. Als elektronische Schalter 4, 8 sind beispielsweise Transistoren, vorzugsweise MOS-Feldeffekt-Transistoren vorgesehen, die durch eins Steuereinrichtung 5 zur Ausführung der einzelnen Prüfschritte selektiv angesteuert werden.

Im Zusammenhang mit der Figur 2 wird nun erläutert, in welcher Weise bei der bekannten Anordnung der Fig. 1 die Prüfschritte im Hinblick auf die Leitfähigkeit der auf der Leiterplatte 1 enthaltenen Leiterbahnen 1" und im Hinblick auf die Isolationswiderstände, die zwischen den Leiterbahnen 1" der Leiterplatte 1 bestehen, ausgeführt werden. In der ersichtlichen Weise ist in der Steuereinrichtung 5 jeder Anschlußpunkt 1' der Leiterplatte 1 über einen Transistor 4 mit Masse und über einen Transistor 8 unter Zwischenschaltung eines Strommeßgerätes 6 mit einer Meßspannung $V_{CC}$ verbunden. Der Einfachheit halber sind in der Fig. 2 die Transistoren 4, 8 als Schalter dargestellt. Zum Zwecke der Erläuterung sind auf der Leiterplatte 1 verschiedene Netzwerke A bis G in der Form von Leiterbahnen 1" dargestellt. Dabei umfassen die Netzwerke A, B, F und G jeweils einen Anschlußpunkt 1'. Das Netzwerk C umfaßt sechs Anschlußpunkte 1' entlang seiner Leiterbahn 1". Das Netzwerk D umfaßt vier Anschlußpunkte 1' entlang seiner Leiterbahn 1". Schließlich weist das Netzwerk E an seiner Leiterbahn 1" zwei Anschlußpunkte 1' auf.

Bei der Prüfung auf die Leitfähigkeit einer bestimmten Leiterbahn 1" wird jeweils so vorgegangen, daß von Anschlußpunkt 1' zu Anschlußpunkt 1' geprüft wird. Zu diesem Zweck werden die Transistoren 4, 8 durch die Steuereinrichtung 5 so angesteuert, daß bei einem Prüfschritt lediglich zwei Transistoren derart durchgeschaltet sind, daß über einen Transistor eine Verbindung zwischen Masse und einem Anschlußpunkt 1' und über den anderen Transistor eine Verbindung zwischen der Meßspannung $V_{CC}$ und einem anderen Anschlußpunkt 1' besteht. Alle anderen Transistoren 4, 8, die der bestimmten Leiterbahn 1" zugeordnet sind, werden bei diesem Prüfschritt durch die Steuereinrichtung 5 gesperrt. Beispielsweise werden zur Prüfung der Leitfähigkeit zwischen den linken beiden Anschlußpunkten 1' des Netzwerkes C die Transistoren C' und C" geschlossen, so daß ein Stromfluß zwischen Masse, dem Transistoren C", dem intakten Bereich der Leiterbahn 1" des Netzwerkes C zwischen den linken beiden Anschlußpunkten 1', dem Transistor C', dem Meßgerät 6 und dem Potential $V_{CC}$ erfolgt.

Wenn im genannten Beispiel das Netzwerk C im Hinblick auf seinen Isolationswiderstand geprüft werden soll, wird in einem weiteren Prüfschritt nur ein einziger Anschlußpunkt des Netzwerkes C über einen Transistor und das Meßgerät 6 mit dem Meßpotential $V_{CC}$ verbunden. Alle anderen Transistoren 4, 8, die mit den Schlußpunkten 1' des Netzwerkes C verbunden sind, werden geöffnet. In der Fig. 2 ist lediglich der linke Anschlußpunkt 1' des Netzwerkes C über den geschlossenen Transistor C' mit dem Meßgerät 6 bzw. dem MeSpotential $V_{CC}$ verbunden. Es ist ersichtlich, daß während dieses Meßschrittes sich die Leckströme aller Transistoren 4 addieren, die mit den Anschlußpunkten 1' des Netzwerkes C verbunden sind. Wenn die Anzahl der Anschlußpunkte 1' des Netzwerkes C sehr groß ist, kommt es daher zu den eingangs erwähnten Verfälschungen des Meßergebnisses.

Zu der Erfindung führten die folgenden Überlegungen. Wenn in ersten Prüfschritten des auszuführenden Prüfverfahrens auf die Leitfähigkeit einer Leiterbahn 1" eines Netzwerkes in an sich bekannter Weise geprüft wird, können die Meßergebnisse der zweiten Prüfschritte zur Messung der Isolationswiderstände bestimmter Netzwerke dadurch verbessert werden, daß bei den zweiten Prüfschritten jeweils nur ein Anschlußpunkt 1' (in Fig. 2 zum Beispiel der linke Anschlußpunkt des Netzwerkes C) pro Netzwerk kontaktiert wird und daß jeweils alle anderen restlichen Anschlußpunkte 1' der Netzwerke durch eine geeignete Maßnahme von den ihnen zugeordneten Transistoren 4, 8 elektrisch getrennt werden. Auf diese Weise kann erreicht werden, daß die Leckströme der diesen restlichen Anschlußpunkten 1' zugeordneten Transistoren 4, 8 nicht in das Meßergebnis eingehen.

Im folgenden wird der beim zweiten Prüfschritt jeweils pro Leiterbahn 1″ zur Messung herangezogene Anschlußpunkt 1′ als Primärpunkt bezeichnet.

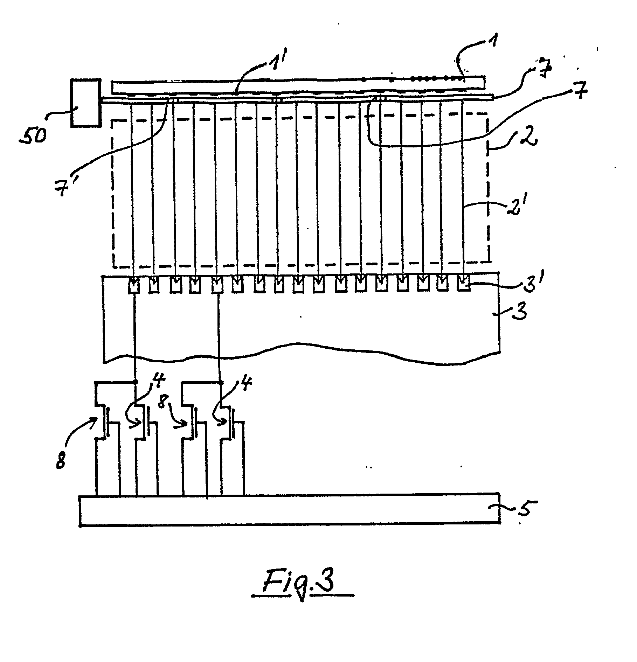

Beispielsweise können während des zweiten Prüfschrittes alle Anschlußpunkte 1′ der Leiterbahnen 1″, bei denen es sich nicht um Primärpunkte handelt, durch eine Maske ausgeblendet werden, die bei der Ausführung des zweiten Prüfschrittes gemäß Figur 3 zwischen die Leiterplatte 1 und die Adaptiervorrichtung 2 derart eingebracht wird, daß sie zur Leiterplatte 1 ausgerichtet ist. In der Figur 3 ist eine derartige Maske mit 7 bezeichnet. In ersichtlicher Weise weist diese Maske 7, die individuell für spezielle Leiterplattenmuster angefertigt wird, Öffnungen 7, auf, die nach dem Ausrichten der Maske 7 in Bezug auf die spezielle Leiterplatte 1 so angeordnet sind, daß nur bestimmte Prüfstifte 2′ durch sie hindurchtreten und einen Kontakt zu den Primärpunkten herstellen können. Durch die Maske 7 wird verhindert, daß zwischen allen anderen Anschlußpunkten 1′ und den Prüfstiften 2′ ein elektrischer Kontakt hergestellt wird, weil die Maske 7 in den diesen Anschlußpunkten zugeordneten Bereichen keine Öffnungen aufweist, durch die die entsprechenden Prüfstifte 2′ hindurchtreten könnten. Die Dicke der Maske 7, die vorzugsweise die Form einer dünnen Platte aufweist, beträgt bei einem möglichen Federweg der Kontaktelemente 3′ des Rasterfeldes 3 von 2–6 mm, vorzugsweise etwa 0,2 mm.

Vorzugsweise weist die Adaptiervorrichtung Justiereinrichtungen 50 auf, durch die sichergestellt wird, daß die Maske 7 vor der Ausführung der zweiten Prüfschritte zur Messung der Isolationswiderstände schnell in die zur Leiterplatte 1 ausgerichteten Position gebracht werden kann.

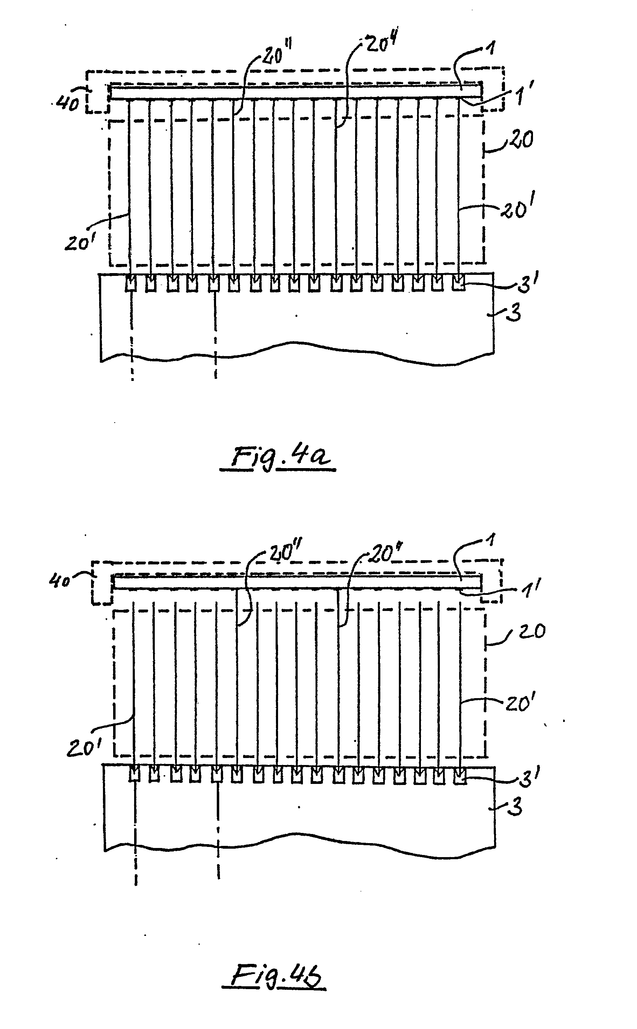

Eine besonders bevorzugte Ausführungsform der Erfindung geht aus der Figuren 4a und 4b hervor, Bei dieser Ausführungsform wird eine Adaptiervorrichtung 20 verwendet, in der unterschiedliche Prüfstifte 20′ und 20″ vorhanden sind, die jeweils in ihrer Längsrichtung federnd ausgebildet sind. Dabei weisen die Prüfstifte 20′ einen kürzen Federweg auf als die Prüfstifte 20″. Dadurch wird erreicht, daß die Leiterplatte 1 gegen die Adaptiervorrichtung 20 derart gedrückt werden kann, daß zur Ausführung der ersten Prüfschritte (Fig. 4a) sämtliche Spitzen der ihr zugewandten Prüfstifte 20′ und 20″ an entsprechenden Anschlußpunkten 1′ der Leiterplatte 1 anliegen, weil die Prüfstifte 20″ so weit zusammen geschoben bzw. verkürzt werden, bis auch die Spitzen der Prüfstifte 20′ an den ihnen entsprechenden Anschlußpunkten 1′ der Leiterplatte 1 anliegen. Zur Ausführung der zweiten Prüfschritte (Fig. 4b) wird die Leiterplatte 1 unter Beibehaltung ihrer Position in Bezug auf die Adaptiervorrichtung 20 so weit angehoben, daß nur noch die Primärpunkten zugeordneten Prüfstifte 20″, die den längeren Federweg aufweisen, an den ihnen zugeordneten Primärpunkten anliegen. Diese Ausführungsform ist gegenüber der in der Figur 3 dargestellten Ausführungsform vorteilhaft, weil das Einführen und Justieren einer Maske 7 nicht erforderlich ist. Beim Übergang von den ersten zu den zweiten Prüfschritten ist es lediglich notwendig, die Leiterplatte 1 in ihrer gegenwärtigen Position festzuhalten und eine vorgegebene Strecke anzuheben. Im Vergleich zu der in der Figur 3 dargestellten Ausführungsform kann daher Zeit eingespart werden.

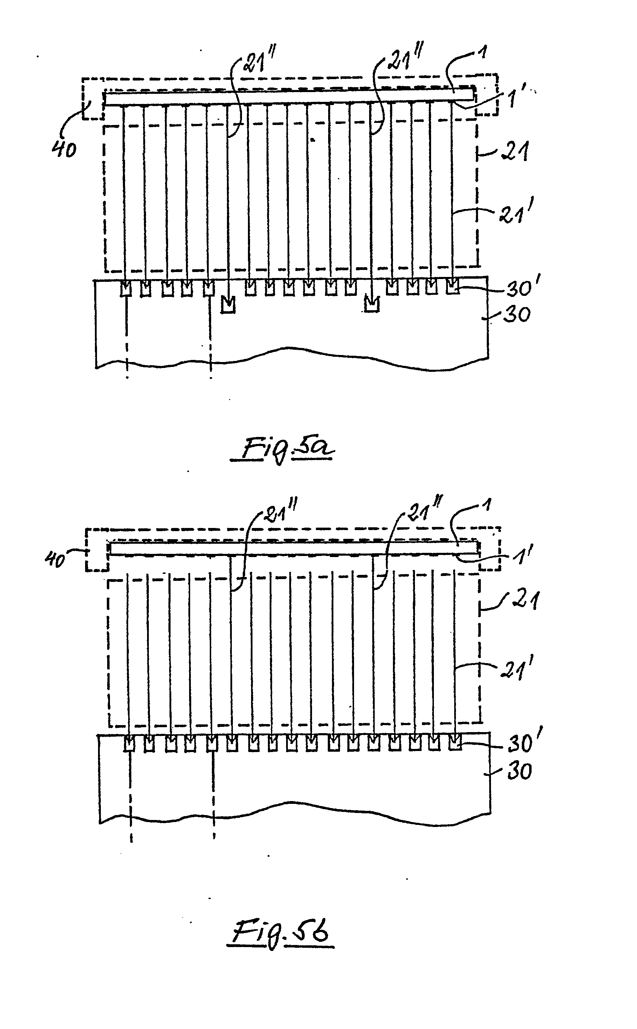

Es ist auch denkbar, an der Stelle von Federstiften 20′ und 20″ mit verschiedenen Federwegen die Kontaktelemente 30′ im Rasterfeld 30 (Fig. 5a, 5b) so auszulegen, daß sie einen relativ großen Federweg aufweisen, d.h., daß sie durch ihnen jeweils zugeordnete Prüfstifte um eine relativ große Strecke in axialer Richtung gegen die Kraft einer Feder bewegt werden können. Während der Federweg bei bekannten Kontaktelementen normalerweise etwa 4 bis 5 mm beträgt, soll der Federweg der vorliegenden Kontaktelemente 30′ etwa 8 bis 10 mm betragen. Es ist dann möglich, als Prüfstifte normale, nicht federnde Stifte 21′ und 21″, z.B. Stahlstifte, zu verwenden, wobei die den Primärpunkten zugeordneten Prüfstifte 21″ länger sind als die den normalen Anschlußpunkten der Leiterplatte 1 zugeordneten Prüfstifte 21′. Auch bei dieser Ausgestaltung wird zunächst zur Messung der Leitfähigkeit die Leiterplatte 1 soweit gegen die Adaptiervorrichtung 21 gedrückt, daß entsprechend der Fig. 5a sämtliche Prüfstifte 21′ und 21″ an den ihnen zugeordneten Anschlußpunkten 1′ der Leiterplatte 1 anliegen. Im Rasterkontaktfeld 30 werden dann die Kontaktelemente, die den Primärpunkten zugeordnet sind, durch die längeren Prüfstifte 21″ weiter eingedrückt als die anderen Prüfstifte 21′. Gemäß Fig. 5b wird dann zur Messung der Isolation die Leiterplatte 1 soweit nach oben angehoben, bis nur noch die den Primärpunkten zugeordneten Prüfstifte 21″ aufgrund ihrer größeren Längen elektrische Verbindungen zwischen dem Rasterkontaktfeld 30 und der Leiterplatten 1 herstellen. Ein Vorteil dieser Ausführungsform besteht insbesondere darin, daß die Prüfstifte 21′, 21″ besonders einfach aufgebaut sind.

Vorzugsweise beträgt der Längenunterschied zwischen den Prüfstiften 21′ und 21″ bei einem möglichen Federweg der Kontaktelemente 30′ des Rasterfeldes 30 von etwa 4–8 mm etwa 2–3 mm.

Bei den Ausführungsformen der Figuren 4a, 4b und 5a, 5b sind vorzugsweise Verschiebeeinrichtungen vorgesehen, durch die eine automatische Verschiebung der Leiterplatte 1 in der Längsrichtung der Prüfstifte unter Beibehaltung ihrer zu den Prüfstiften ausgerichteten Position zwischen den ersten und zweiten Prüfschritten möglich ist. Derartige Verschiebeeinrichtungen sind in den genannten Figuren schematisch dargestält und mit 40 bezeichnet.

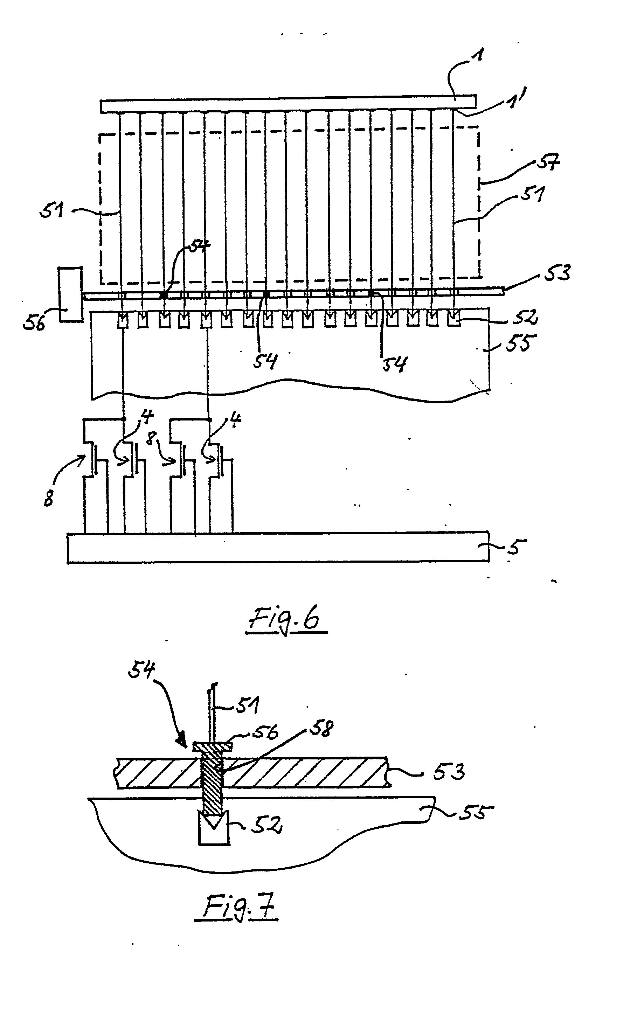

Aus den Figuren 6 und 7 geht eine weitere Vorrichtung zur Durchführung des erfindungsgemäßen Verfahrens hervor, die ein Zwischenkontaktfeld 53 aufweist, das vor der Ausführung der anderen Verfahrensschritte zwischen die dem Kontaktfeld 55 zugewandten Enden der Prüfstifte 51 einer Adaptiervorrichtung 57 und das Kontaktfeld 55 eingebracht wird. Das Zwischenkontaktfeld 53 weist vorzugsweise die Form einer elektrisch isolierenden Platte auf, die mit Durchgangslöchern 58 versehen ist, die entsprechend dem Raster des Kontaktfeldes 55 vorgesehen sind. Dabei wird das Zwischenkontaktfeld 53 unter Zuhilfenahme eines in der Fig. 6 schematisch dargestellten Anschlagelementes 56 derart in Bezug auf das Kontaktfeld 55 ausgerichtet, daß die Durchgangslöcher 58 zu den Kontaktelementen 52 des Kontaktfeldes 55 ausgerichtet sind. In einzelne Durchgangslöcher 58 können selektiv Kontaktglieder 54 eingebracht werden, die elektrische Verbindungen zwischen einzelnen Prüfstiften 51 und den entsprechenden Kontaktelementen 52 des Kontaktfeldes 55 herstellen. Dabei werden die Kontaktglieder 54 selektiv den Primärpunkten entsprechend angeordnet.

Aus der Fig. 7, die schematisch ein in ein Durchgangsloch 58 einer das Zwischenkontaktfeld 53 bildenden isolierenden Platte eingesetztes Kontaktglied 54 zeigt, geht hervor, daß dieses Kontaktglied 54 vorzugsweise die Form eines stiftähnlichen Elementes aufweist, das an einer Seite mit einem Ansatz 59 versehen ist, der beim selektiven Einsetzen des stiftähnlichen Kontaktgliedes 54 verhindert, da ßdas stiftähnliche Kontaktglied 54 durch das entsprechende Durchgangsloch 58 hindurchtritt. Beim zweiten Prüfschritt werden elektrische Verbindungen zwischen den Primärpunkten der Leiterplatte 1 nur über die selektiv vorgesehenen Kontaktglieder 54 hergestellt, die elektische Verbindungen zwischen den ihnen zugeordneten Prüfstiften 51 und den entsprechenden Kontaktelementen 52 bewirken.

Ein wesentlicher Vorteil dieser Adaptiervorrichtung besteht darin, daß die selektive Bestückung des Zwischenkontaktfeldes 53 in der Form einer elektrisch isolierenden Platte mit den Kontaktgliedern 54 relativ einfach möglich ist, weil die Orte, an denen diese Kontaktglieder 54 selektiv anzuodnen sind, in Koordinaten sehr leicht anzugeben sind, so da ßeine automatische Bestückung des Zwischenkontaktfeldes 53 erfolgen kann.

Besonders einfach kann diese automatische Bestückung beispielsweise so erfolgen, daß eine zusätzliche dünne Folie, die zweckmäßigerweise aus Kunststoff oder Papier bestehen kann, verwendet wird, die nur an den zu bestückenden Durchgangslöchern 58 der rastergebundenen Zwischenkontaktfeldes 53 Öffnungen aufweist. Diese Folie wird zunächst zum Zwischenkontaktfeld 53 ausgerichtet und auf diese aufgelegt bzw. aufgebracht. Anschließend wird eine rastergebundene Kassette oder dergl., die an jedem Rasterpunkt ein Kontaktglied 54 aufweist, zum Zwischenkontaktfeld 53 ausgerichtet und derart gehandhabt und auf das Zwischenkontaktfeld 53 aufsetzt, daß aus ihr nur die Kontaktglieder 54 herausfallen und in entsprechende Durchgangslöcher 58 des Zwischenkontaktfeldes 53 eintreten, diean den Stellen vorgesehen sind, an denen jeweils eine Öffnung der Folie zu einem Durchgangsloch 58 ausgerichtet ist. Alle anderen Kontaktglieder 54 der Kassette können nicht in das Zwischenkontaktfeld 53 bzw. in entsprechende Durchgangslöcher 58 desselben eintreten, weil die Folie an den Stellen dieser Durchgangslöcher 58 keine Öffnungen aufweist.

## Patentansprüche

1. Verfahren zum elektrischen Prüfen von Verdrahtungsträgern, wie Leiterplatten, Keramik-Leiterplatten, gedruckten Schaltungen und flexiblen Schaltungen, bei dem in einem Verfahrensschritt die Leitfähigkeit der auf der Leiterplatte (1) befindlichen Leiterbahnen (1″) durch Messen der Leitfähigkeit zwischen Anschlußpunkten (1′) bestimmt wird, die sich auf einer bestimmten Leiterbahn (1) befinden, und bei dem in anderen Verfahrensschritten der Isolationswiderstand zwischen Leiterbahnen (1″) durch Messen des Stromflusses zwischen einer bestimmten Leiterbahn (1″) und den anderen Leiterbahnen (1″) bestimmt wird, wobei jedem Anschlußpunkt (1′) der Leiterbahnen (1″) jeweils ein erster elektronischer Schalter (4) und ein zweiter elektronischer Schalter (8) zugeordnet sind, wobei bei dem einen Verfahrensschritt jeweils ein Anschlußpunkt (1′) einer bestimmten Leiterbahn (1″) über den dem Anschlußpunkt (1′) zugeordneten ersten elektronischen Schalter (4) mit einem ersten Potential verbunden und ein anderer Anschlußpunkt der bestimmten Leiterbahn (1″) über den diesem anderen Anschlußpunkt zugeordneten zweiten elektronischen Schalter (8) und ein Strommeßgerät (6) mit einem zweiten Potential (Vcc) verbunden wird, wobei bei den anderen Verfahrensschritten jeweils über einen einem Anschlußpunkt (1′) einer bestimmten Leiterbahn (1″) zugeordneten zweiten elektronischen Schalter (8) und das Strommeßgerät (6) eine Verbindung zu dem zweiten Potential (Vcc) hergestellt wird, im wesentlichen alle anderen Anschlußpunkte (1′) der bestimmten Leiterbahn (1″) von dem ersten und zweiten Potential (Vcc) getrennt werden, und jeweils ein Anschlußpunkt (1′) der anderen Leiterbahnen (1″) über den ihm jeweils zugeordneten ersten elektronischen Schalter (4) mit dem ersten Potential verbunden wird und im wesentlichen alle Anschlußpunkte (1′) der anderen Leiterbahnen (1″) von dem zweiten Potential (Vcc) getrennt werden, wobei die elektrischen Verbindungen zwischen den Anschlußpunkten (1′) und den entsprechenden ersten und zweiten elektronischen Schaltern (4, 8) jeweils über Prüfstifte (2′) einer Adaptiervorrichtung (2) und über ein Kontaktelemente (3, 30′, 52) aufweisendes Kontaktfeld (3, 30, 55) hergestellt werden, dadurch gekennzeichnet, daß vor der Ausführung der anderen Verfahrensschritte durch eine Einrichtung (7: 20′, 20″, 21′, 21‴, 53) bewirkt wird, daß pro Leiterbahn (1 ″), abgesehen von der einen genannten Verbindung zwischen dem einen Anschlußpunkt (1′) und dem zweiten Potential (Vcc) im wesentlichen alle anderen Verbindungen zu den Anschlußpunkten (1′) der Leiterbahn (1″) mechanisch unterbrochen werden.

2. Verfahren nach Anspruch 1, dadurch gekennzeichnet, daß vor der Ausführung der anderen Verfahrensschritte zwischen die der Leiterplatte (1) zugewandten Enden der Prüfstifte (2′) der Adaptiervorrichtung (2) und die Leiterplatte (1) eine nichtleitende Maske (7) eingebracht und derart ausgerichtet wird, daß pro Leiterbahn ein Prüfstift durch eine Öffnung (7″) der Maske (7) hindurchragt, um eine elektrische Verbindung zwischen dem jeweils einen Anschlußpunkt (1') der Leiterbahn und dem zugeordneten ersten (4) und zweiten (8) elektronischen Schalter herzustellen.

3. Verfahren nach Anspruch 1, dadurch gekennzeichnet, daß die Adaptiervorrichtung (21) Prüfstifte (21', 21") unterschiedlicher Länge aufweist, daß der Längenunterschied zwischen den Prüfstiften (21', 21") so bemessen ist, daß er kleiner ist als der Federweg von Kontaktelementen (30') eines Kontaktfeldes (30), in die die der Leiterplatte (1) abgewandten Enden der Prüfstifte (21', 21") zur Herstellung der elektrischen Verbindungen mit den ersten und zweiten elektronischen Schaltern (4, 5) eingreifen, daß bei den einen Verfahrensschritten über alle Prüfstifte (21', 21") elektrische Verbindungen zwischen den Anschlußpunkten (1') der Leiterplatte (1) und entsprechenden Kontaktelementen (30') des Kontaktfeldes (30) hergestellt werden, und daß vor den anderen Verfahrensschritten die Leiterplatte (1) unter Beibehaltung ihrer ausgerichteten Position derart angehoben wird, daß die elektrischen Verbindungen zwischen den kurzen Prüfstiften (21') und den ihnen zugeordneten Anschlußpunkten (1') der Leiterbahnen (1") unterbrochen werden und daß über jeweils einen langen Prüfstift (21") pro Leiterbahn eine elektrische Verbindung zwischen dem jeweils einen Anschlußpunkt der Leiterbahn und dem entsprechenden Kontaktelement (30') des Kontaktfeldes (30) bestehen bleibt.

4. Verfahren nach Anspruch 1, dadurch gekennzeichnet, daß die Adaptiervorrichtung (20) federnde Prüfstifte (20', 20") mit unterschiedlichen Federwegen aufweist, daß bei den einen Verfahrensschritten über alle Prüfstifte (20', 20") elektrische Verbindungen zwischen den Anschlußpunkten (1') der Leiterplatte (1) und entsprechenden Kontaktelementen (3') des Kontaktfeldes (3) in die die der Leiterplatte (1) abgewandten Enden der Prüfstifte (20', 20") zur Herstellung der elektrischen Verbindungen mit den ersten und zweiten elektronischen Schaltern (4, 5) eingreifen, hergestellt werden, und daß vor den anderen Verfahrensschritten die Leiterplatte (1) unter Beibehaltung ihrer ausgerichteten Position derart angehoben wird, daß die elektrischen Verbindungen zwischen den Prüfstiften (20') mit den kurzen Federwegen und den ihnen zugeordneten Anschlußpunkten (1') der Leiterbahnen (1") unterbrochen werden und daß über jeweils einen Prüfstift (20") mit einem langen Federweg pro Leiterbahn (1") eine elektrische Verbindung zwischen dem jeweils einen Anschlußpunkt der Leiterbahn (1") und dem entsprechenden Kontaktelement (3') des Kontaktfeldes (3) bestehen bleibt.

5. Verfahren nach Anspruch 1, dadurch gekennzeichnet, daß vor der Ausführung der anderen Verfahrensschritte zwischen die dem Kontaktelemente (52) aufweisenden Kontaktfeld (55) zugewandten Enden der Prüfstifte (51) und die Kontaktelemente (52) des Kontaktfeldes (55) ein dem Raster des Kontaktfeldes (55) entsprechend rastergebundenes Zwischenkontaktfeld (53) eingebracht und derart ausgerichtet wird, daß pro Leiterbahn (1") ein Prüfstift über ein starres Kontaktglied (54) des Zwischenkontaktfeldes (53) eine elektrische Verbindung zwischen dem jeweils einen Anschlußpunkt (1') der Leiterbahn (1") und dem entsprechenden Kontaktelement (52) herstellt, das dem dem Anschlußpunkt (1') zugeordneten ersten (4) und zweiten (8) elektronischen Schalter vorgeschaltet ist.

6. Vorrichtung zur Durchführung des Verfahrens nach Anspruch 2, mit einer Adaptiervorrichtung (2), in der mittels Prüfstifte (2') elektrische Verbindungen zwischen Kontaktelementen (3') des Kontaktfeldes (3) und den Anschlußpunkten (1') der Leiterbahnen (1") einer in der Vorrichtung gehaltenen Leiterplatte (1) herstellbar sind, wobei jedem Kontaktelement (52) ein erster elektronischer Schalter (4), durch den eine elektrische Verbindung mit einem ersten Potential herstellbar ist, und ein zweiter elektronischer Schalter (8) zugeordnet sind, mit dem eine elektrische Verbindung mit einem zweiten Potential ($V_{cc}$) herstellbar ist, dadurch gekennzeichnet, daß die Adaptiervorrichtung (2) eine nichtleitende Maske (7) aufweist, die pro Leiterbahn (1") der Leiterplatte (1) eine Öffnung (7') aufweist, durch die nach Ausrichtung der Maske (7) in Bezug auf die Leiterplatte (1) ein Prüfstift (2') zur Kontaktherstellung zu einem Anschlußpunkt (1') der Leiterbahn (1") hindurchführbar ist.

7. Vorrichtung nach Anspruch 6, dadurch gekennzeichnet, daß die Maske (7) die Form einer dünnen isolierenden Platte mit Öffnungen (7') aufweist.

8. Vorrichtung nach Anspruch 7, dadurch gekennzeichnet, daß die Platte bei einem möglichen Federweg des Kontaktelemente (3') des Rasterfeldes (3) von 2–6 mm eine Dicke von etwa 0,2 mm aufweist.

9. Vorrichtung nach einem der Ansprüche 6 bis 8, dadurch gekennzeichnet, daß Justiereinrichtungen (50) vorgesehen sind, durch die die Maske (7) vor Ausführung der anderen Verfahrensschritte in eine zur Leiterbahn (1) ausgerichtete Position bringbar ist.

10. Vorrichtung zur Durchführung des Verfahrens nach Anspruch 3, mit einer Adaptiervorrichtung (21), in der elektrische Verbindungen zwischen Kontaktelementen (30') des Kontaktfeldes (30) und den Anschlußpunkten (1') der Leiterbahnen (1") einer in der Vorrichtung gehaltenen Leiterplatte (1) herstellbar sind, wobei jedem Kontaktelement (30') jeweils ein erster elektronischer Schalter (4), durch den eine elektrische Verbindung mit einem ersten Potential herstellbar ist, und ein zweiter elektronischer Schalter (8) zugeordnet sind, durch den eine elektrische Verbindung mit einem zweiten Potential ($V_{cc}$) herstellbar ist, dadurch gekennzeichnet, daß die Adaptiervorrichtung (21) kürzere Prüfstifte (21') und längere Prüfstifte (21") aufweist, daß jeweils ein längerer Prüfstift (21") so angeordnet ist, daß er dem einen Anschlußpunkt (1') einer Leiterbahn (1") der Leiterplatte (1) zugeordnet ist, und daß der Längenunterschied zwischen den kurzen und langen Prüfstiften (21', 21") kleiner ist, als der mögliche Federweg der Kontaktelemente (30') des der Adaptiervorrichtung (21) zugeordneten Kontaktfeldes (30).

11. Vorrichtung nach Anspruch 10, dadurch gekennzeichnet, daß der Längenunterschied bei einem möglichen Federweg der Kontaktelemente (30′) von etwa 4–8 mm in einem Bereich von etwa 2–3 mm liegt.

12. Vorrichtung zur Durchführung des Verfahrens nach Anspruch 4, mit einer Adaptiervorrichtung (20), in der elektrische Verbindungen zwischen Kontaktelementen (3′) eines Kontaktfeldes (3) und den Anschlußpunkten (1′) der Leiterbahnen (1″) einer in der Vorrichtung gehaltenen Leiterplatte (1) herstellbar sind, wobei jedem Kontaktelement (3′) jeweils ein erster elektronischer Schalter (4), durch den eine elektrische Verbindung mit einem ersten Potential herstellbar ist, und ein zweiter elektronischer Schalter (8) zugeordnet sind, durch den eine elektrische Verbindung mit einem zweiten Potential ($V_{cc}$) herstellbar ist, dadurch gekennzeichnet, daß die Adaptiervorrichtung (20) in Längsrichtung federnde Prüfstifte (20′) mit kürzeren Federwegen und in Längsrichtung federnde Prüfstifte (20″) mit längeren Federwegen aufweist und daß jeweils ein Prüfstift (20″) mit einem längeren Federweg so angeordnet ist, daß er dem einen Anschlußpunkt (1′) einer Leiterbahn (1″) der Leiterplatte (1) zugeordnet ist.

13. Vorrichtung nach einem der Ansprüche 9 bis 12, dadurch gekennzeichnet, daß eine Verschiebeeinrichtung (40) vorgesehen ist, durch die die Leiterplatte (1) unter Beibehaltung ihrer zu den Prüfstiften (20′, 20″) ausgerichteten Position in der Längsrichtung der Prüfstifte (20′, 20″) um eine vorgegebene Strecke bewegbar ist.

14. Vorrichtung zur Durchführung des Verfahrens nach Anspruch 5, mit einer mit Prüfstiften (51) versehenen Adaptiervorrichtung (57), über die elektrische Verbindungen zwischen Kontaktelementen (52) eines Kontaktfeldes (55) und den Anschlußpunkten (1′) der Leiterbahnen (1″) einer in der Vorrichtung gehaltenen Leiterplatte (1) herstellbar sind, wobei jedem Kontaktelement (52) jeweils ein erster elektronischer Schalter (4), durch den eine elektrische Verbindung mit einem ersten Potential herstellbar ist, und ein zweiter elektronischer Schalter (8) zugeordnet sind, durch den über ein Strommeßgerät (6) eine elektrische Verbindung mit einem zweiten Potential ($V_{cc}$) herstellbar ist, dadurch gekennzeichnet, daß sie vor dem Kontaktfeld (55) ein dem Raster des Kontaktfeldes (55) entsprechend rastergebundenes Zwischenkontaktfeld (53) aufweist, das an den einzelnen Rasterpunkten mit Durchgangslöchern (58) versehen ist, in die selektiv starre Kontaktglieder (54) zur Herstellung der elektrischen Verbindungen zwischen jeweils einem Anschlußpunkt (1′) einer Leiterbahn (1″) und dem entsprechenden Kontaktelement (52) des Kontaktfeldes (55) einsetzbar sind.

15. Vorrichtung nach Anspruch 14, dadurch gekennzeichnet, daß das Zwischenkontaktfeld die Form einer isolierenden Platte (53) aufweist, in deren Durchgangslöcher (58) selektiv stiftähnliche Elemente (54) als Kontaktglieder einsetzbar sind.

16. Vorrichtung nach Anspruch 15, dadurch gekennzeichnet, daß die stiftähnlichen Elemente (54) über ihren Umfang hinausragende Ansätze (56) aufweisen, die als Anschläge dienen und die Einschubbewegung von einer Seite der Platte (53) her beenden.

**Revendications**

1. Procédé d'essai électrique de supports de câblage comme des plaquettes à conducteurs, des plaquettes céramiques à conducteurs, des circuits imprimés et des circuits souples, dans lequel, dans une étape du procédé, la conductibilité des pistes conductrices (1″) situées sur la plaquette à conducteurs (1) est déterminée par une mesure de la conductibilité entre des points de Liaison (16) qui se trouvent sur une piste conductrice déterminée (1″), et dans lequel, dans d'autres étapes du procédé, la résistance d'isolement entre des pistes conductrices (1″) est déterminée par une mesure de la conduction de courant entre une piste conductrice déterminée (1″) et les autres pistes conductrices (1″), à chaque point de liaison (1′) des pistes conductrices (1″) étant respectivement associé un premier commutateur électronique (4) et un second commutateur électronique (8), lors de ladite une étape du procédé respectivement, un point de liaison (1′) d'une piste conductrice déterminée (1″) étant relié à un premier potentiel par le premier commutateur électronique (4) associé au point de liaison (1′) et un autre point de liaison de la piste conductrice déterminée (1″) étant relié à un second potentiel ($V_{CC}$) par le second commutateur électronique (8) associé à cet autre point de liaison et par un instrument de mesure du courant (6), et lors des autres étapes du procédé, une liaison au second potentiel ($V_{CC}$) étant réalisée respectivement par un second commutateur électronique (3) associé à un point de liaison (1′) d'une piste conductrice (1 ″) déterminée et par l'instrument de mesure de courant (6), tous les autres points de liaison (1′) de la piste conductrice (1″) déterminée étant essentiellement séparés du premier et du second potentiel ($V_{CC}$) et un point de liaison (1′) des autres pistes conductrices (1″) étant relié respectivement, par le premier commutateur électronique (4) qui lui est respectivement associé, au premier potentiel et tous les points de liaison (1′) des autres pistes conductrices (1″) étant essentiellement séparés du second potentiel ($V_{CC}$), et les liaisons électriques entre les points de liaison (1′) et les premiers et seconds commutateurs électroniques correspondants (4, 8) étant réalisées respectivement par des broches d'essai (2′) d'un dispositif d'adaptation (2) et par une zone de contact (3, 30, 55) présentant des éléments de contact (3, 30′, 52), caractérisé en ce qu'avant que l'exécution des autres étapes du procédé soit accomplie par un dispositif (7; 20′, 20″, 21′, 21 ′″, 53), par piste conductrice (1″), à l'exception de ladite une liaison entre ledit un point de liaison (1′) et le second potentiel ($V_{CC}$), toutes les autres liaisons aux points de liaison (1′) de la piste conductrice (1″) sont essentiellement interrompues mécaniquement.

2. Procédé suivant la revendication 1, caractérisé en ce qu'avant l'exécution des autres étapes du procédé, entre les extrémités, qui sont tournées vers la plaquette à conducteurs (1), des broches d'essai (2') du dispositif d'adaptation (2) et la plaquette à conducteurs (1), un masque non conducteur (7) est placé et aligné de façon que, par piste conductrice, une broche d'essai fait saillie au travers d'une ouverture (7') du masque (7) afin de réaliser une liaison électrique entre ledit un point de liaison (1') respectif de la piste conductrice et les premier (4) et second (8) commutateurs électroniques associés.

3. Procédé suivant la revendication 1, caractérisé en ce que le dispositif d'adaptation (21) présente des broches d'essai (21', 21") de longueurs différentes, en ce que la différence de longueur entre les broches d'essai (21', 21") est dimensionnée de façon qu'elle soit inférieure au déplacement élastique d'éléments de contact (30') d'une zone de contact (30) dans laquelle entrent en contact les extrémités, opposées à la plaquette à conducteurs (1), des broches d'essai (21', 21") pour la réalisation des liaisons électriques avec les premiers et seconds commutateurs électronique (4, 8), en ce que lors desdites unes étapes du procédé, des liaisons électriques entre les points de liaison (1') de la plaquette à conducteurs (1) et des éléments de contact (30') correspondants de la zone de contact sont réalisées par toutes les broches d'essai (21', 21") et en ce qu'avant les autres étapes du procédé la plaquette à conducteurs (1) est soulevée en maintenant sa position alignée de façon que les liaisons électriques entre les broches d'essai courtes (21') et les points de liaison (1'), qui y sont associés, des pistes conductrices (1") soient interrompues et en ce que par piste conductrice une liaison électrique entre ledit un point de liaison respectif de la piste conductrice et l'élément de contact correspondant (30') de la zone de contact (30) est maintenue par une longue broche d'essai (21") respective.

4. Procédé suivant la revendication 1, caractérisé en ce que le dispositif d'adaptation (20) présente des broches d'essai faisant ressort (20', 20") avec différents déplacements élastiques, en ce que, lors desdites unes étapes du procédé, sont réalisées par toutes les broches d'essai (20', 20") des liaisons électriques entre les points de liaison (1') de la plaquette à conducteurs (1) et les éléments de contact (3') correspondants de la zone do contact (3) dans lesquels les extrémités, qui sont opposées à la plaquette à conducteurs (1), des broches d'essai (20', 20") entrent en contact pour la réalisation des liaisons électriques avec les premiers et seconds commutateurs électroniques (4, 8) et en ce qu'avant les autres étapes du procédé la plaquette à conducteurs (1) est soulevée en maintenant sa position alignée de façon que les liaisons électriques entre les broches d'essai (20') qui ont de courts déplacements élastiques et les points de liaison (1'), qui leurs sont associés, des pistes conductrices (1") sont interrompues et en ce que par une broche d'essai (20") respective à long déplacement élastique, par piste conductrice (1"), une liaison électrique entre ledit un point de liaison respectif de la piste conductrice (1") et l'élément de contact (3') correspondant de la zone de contact (3) est maintenue.

5. Procédé suivant la revendication 1, caractérisé en ce qu'avant l'exécution des autres étapes du procédé, entre les extrémités, tournées vers la zone de contact (55) présentant des éléments de contact (52), des broches d'essai (51) et les éléments de contact (52) de la zone de contact (55), une zone de contact intermédiaire (53) à grille fixe, conformément à la grille de base de la zone de contact (55), est placée et alignée de façon que par piste conductrice (1") une broche d'essai réalise par un élément de contact fixe (54) de la zone de contact intermédiaire (53) une liaison électrique entre ledit un point de liaison (1é) respectif do la piste conductrice (1") et l'élément de contact (52) correspondant qui est monté en amont des premier (4) et second (8) commutateurs électroniques associés au point de liaison (1, ).

6. Dispositif pour la mise en oeuvre du procédé suivant la revendication 2, comprenant un dispositif d'adaptation (2) dans lequel des liaisons électriques entre des éléments de contact (3') de la zone de contact (3) et les points de liaison (1') des pistes conductrices (1") d'une plaquette à conducteurs (1) maintenue dans le dispositif peuvent être réalisées au moyen de broches d'essai (2'), à chaque élément de contact (52) étant associés un premier commutateur électronique (4) au travers duquel une liaison électrique peut être réalisée avec un premier potentiel et un second commutateur électronique (8) par lequel une liaison électrique peut être réalisée avec un second potentiel (Vcc), caractérisé en ce que le dispositif d'adaptation (2) présente un masque non conducteur (7) qui présente par piste conductrice (1") de la plaquette à conducteurs (1) une ouverture (7') au travers de laquelle, après l'alignement du masque (7) par rapport à la plaquette à conducteurs (1), une broche d'essai (2') peut être introduite pour la réalisation du contact avec un point de liaison (1') de la piste conductrice (1").

7. Dispositif suivant la revendication 6, caractérisé en ce que le masque (7) présente la forme d'une plaque isolante mince comportant des ouvertures (7').

8. Dispositif suivant la revendication 7, caractérisé en ce que, lors d'un déplacement élastique possible des éléments de contact (3') de la zone de grille de base (3) compris entre 2 et 6 mm, la plaque présente une épaisseur d'approximativement 0, 2 mm.

9. Dispositif suivant l'une quelconque des revendications 6 à 8, caractérisé en ce que sont prévus des dispositifs d'ajustage (50) par lesquels le masque (7) peut être placé dans une position alignée par rapport à la piste conductrice (1") avant l'exécution des autres étapes du procédé.

10. Dispositif pour la mise en oeuvre du procédé suivant la revendication 3, comportant un dispositif d'adaptation (21) dans lequel les liaisons électriques entre des éléments de contact (30') de la zone de contact (30) et les points de liaison (1') des pistes conductrices (1") d'une plaquette à conducteurs (1) maintenue dans le dispositif peuvent être réalisées, à chaque élément de contact (30') étant associés respectivement un premier commutateur électronique (4) par lequel peut être réalisée une liaison électrique avec un premier potentiel et un second commutateur électronique (8) par lequel peut être réalisée ladite une liaison électrique avec un second potentiel (Vcc), caractérisé en ce que le dispositif d'adaptation (21) présente des broches d'essai plutôt courtes (21') et des broches d'essai plutôt longues (21"), en ce que respectivement une broche d'essai plutôt longue (21") est agencée de façon qu'elle soit associée audit un point de liaison (1') d'une piste conductrice (1") de la plaquette à conducteurs (1) et en ce que la différence de longueur entre les courtes et les longues broches d'essai (21', 21") est inférieure au déplacement élastique possible des éléments de contact (30') de la zone de contact (30) associée au dispositif d'adaptation (21).

11. Dispositif suivant la revendication 10, caractérisé en ce que la différence de longueur se situe dans une zone d'approximativement 2 à 3 mm pour un déplacement élastique possible des éléments de contact (30') d'approximativement 4 à 8 mm.

12. Dispositif pour la mise en oeuvre du procédé suivant la revendication 4, comportant un dispositif d'adaptation (20) dans lequel peuvent être réalisées des liaisons électriques entre des éléments de contact (3') d'une zone de contact (3) et les points de liaison (1') des pistes conductrices (1") d'une plaquette à conducteurs (1) maintenue dans le dispositif, à chaque élément de contact (3') étant associés respectivement un premier commutateur électronique (4) par lequel est réalisée une liaison électrique avec un premier potentiel et un second commutateur électronique (8) par lequel est réalisée une liaison électrique avec un second potentiel (Vcc), caractérisé en ce que le dispositif d'adaptation (20) présente des broches d'essai (20') faisant ressort dans la direction longitudinale et présentant des déplacements élastiques plutôt courts et des broches d'essai (20") faisant ressort dans la direction longitudinale et présentant des déplacements élastiques plutôt longs, et en ce que respectivement une broche d'essai (20") qui présente un déplacement élastique plutôt long est agencée de façon qu'elle soit associée audit un point de liaison (1') d'une piste conductrice (1") de la plaquette à conducteurs (1).

13. Dispositif suivant l'une quelconque des revendications 9 à 12, caractérisé en ce qu'est prévu un dispositif de déplacement (40) par lequel la plaquette à conducteurs (1) peut être déplacée d'une distance donnée dans la direction longitudinale des broches d'essai (20', 20") en maintenant sa position alignée par rapport aux broches d'essai (20', 20").

14. Dispositif de mise en oeuvre du procédé suivant la revendication 5, comportant un dispositif d'adaptation (57) qui est pourvu de broches d'essai (51) et par lequel peuvent être réalisées des liaisons électriques entre des éléments de contact (52) d'une zone de contact (55) et les points de liaison (1') des pistes conductrices (1") d'une plaquette à conducteurs (1) maintenue dans le dispositif, à chaque élément de contact (52) étant respectivement associés un premier commutateur électronique (4) par lequel peut être réalisée ladite une liaison électrique avec un premier potentiel et un second commutateur électronique (9) par lequel peut être réalisée au travers d'un appareil de mesure de courant (6) une liaison électrique avec un second potentiel (Vcc), caractérisé en ce qu'il présente avant la zone de contact (55) une zone de contact intermédiaire (53) qui est à grille fixe conformément à la grille de base de la zone de contact (55) et qui est pourvu, aux points de grille de base individuels, de trous de passage (58) dans lesquels peuvent être insérés des éléments de contact sélectivement fixes (54) pour la réalisation des liaisons électriques entre respectivement un point de liaison (1') d'une piste conductrice (1") et l'élément de contact (52) correspondant de la zone de contact (55).

15. Dispositif suivant la revendication 14, caractérisé en ce que la zone de contact intermédiaire présente la forme d'une plaque isolante (53) dans des trous de passage (58) de laquelle des éléments (54) sélectivement semblables à des broches peuvent être insérés en tant qu'éléments de contact.

16. Dispositif suivant la revendication 15, caractérisé en ce que les éléments (54) semblables à des broches présentent des excroissances (56) qui font saillie sur leur périphérie et qui servent de butées et limitent me déplacement le à partir d'un côté de la plaque (53).

**Claims**

1. Method of testing wiring supports, such as printed circuit boards, ceramic circuit boards, printed circuits and flexible circuits, wherein in one processing step the conductivity of the conductors (1") located on the circuit board (1) is determined by measuring the conductivity between connection points (1') which are located on a specific conductor (1"), and wherein in other processing steps the insulation resistance between conductors (1") is determined by measuring the current flowing between a specific conductor (1"), and the other conductors (1"), a first electronic switch (4) and a second electronic switch (8) being associated with each connection point (1') of the conductors (1") and, in the one processing step, a connection point (1') of a specific conductor (1") being connected to a first potential by the first electronic switch (4) associated with the connection point (1') and another connection point of the specific conductor (1") being connected to a second potential (Vcc) by the second electronic switch (8) associated with this other connection point and by a current measuring element (6), and, in the other processing steps, by means of a second electronic switch (8) associated with a connection point (1') of a specific conductor (1") and by means of the current measuring element (6) a connection being established with the second potential (Vcc), substantially all of the other connection points (1') of the specific conductor (1") being isolated from the first and second potential (Vcc), and a connection point (1') of the other conductors (1") being connected to the first potential by the first electronic switch (4) associated with it and substantially all the connection points (1') of the other conductors (1") being isolated from the second potential (Vcc), with the electrical connections between the connection points (1') and the corresponding first and second electronic switches (4, 8) being established in each case by means of test pins (2') of an adaptor device (2) and by means of a contact bank (3, 30, 55) having contact elements (3, 30', 52), characterised in that, prior to carrying out the other processing steps, a device (7; 20', 20", 21', 21", 53) produces the effect that in each conductor (1") substantially all the connections to the connection points (1') of the conductor (1") except for the said one connection between the one connection point (1') and the second potential ($V_{cc}$) are mechanically interrupted.

2. Method according to claim 1, characterised in that, prior to carrying out the other processing steps, a non-conducting mask (7) is introduced between the ends of the test pins (2') of the adaptor device (2) facing the circuit board (1) and the circuit board (1) and is aligned in such a way that one test pin per conductor projects through an opening (7') in the mask (7) so as to establish an electrical connection between the one connection point (1') of the conductor and the associated first (4) and second (8) electronic switch.

3. Method according to claim 1, characterised in that the adaptor device (21) has test pins (21', 21") of varying length, in that the difference in length between the test pins (21', 21") is such that it is smaller than the spring excursion of contact elements (30') of a contact bank (30) into which the ends of the test pins (21', 21") remote from the circuit board (1) engage to establish the electrical connections with the first and second electronic switches (4, 5), in that during the one set of processing steps electrical connections are established by way of all the test pins (21', 21") between the connection points (1') of the circuit board (1) and corresponding contact elements (30') of the contact bank (30), and in that prior to the other processing steps the circuit board (1) is raised, while maintaining its aligned position, in such a manner that the electrical connections between the short test pins (21') and their associated connection points (1') of the conductors (1") are interrupted and an electrical connection between the one connection point of the conductor and the corresponding contact element (30') of the contact bank (30) is maintained by means of one long test pin (21") per conductor.

4. Method according to claim 1, characterised in that the adaptor device (20) has spring test pins (20', 20") of varying spring excursion, in that in the one set of processing steps electrical connections are established by means of all the test pins (20', 20") between the connection points (1') of the circuit board (1) and corresponding contact elements (3') of the contact bank (3) into which the ends of the test pins (20', 20") remote from the circuit board (1) engage in order to establish the electrical connections with the first and second electronic switches (4, 5), and in that prior to the other processing steps the circuit board (1) is raised, while maintaining its aligned position, in such a manner that the electrical connections between the test pins (20') having a short spring excursion and their associated connection points (1'), of the conductors (1") are interrupted and an electrical connection between the one connection point of the conductor (1") and the corresponding contact element (3') of the contact bank (3) is maintained by means of one test pin (20") having a long spring excursion per conductor (1").

5. Method according to claim 1, characterised in that prior to carrying out the other processing steps an intermediate contact bank (53) fixed in a grid corresponding to the grid of the contact bank (55) is introduced between the ends of the test pins (51) facing the contact bank (55) with the contact elements (52) and the contact elements (52) of the contact bank (55) and is aligned in such a way that one test pin per conductor (1") by means of a rigid contact element (54) of the intermediate contact bank (53) establishes an electrical connection between the one connection point (1') of the conductor (1") and the corresponding contact element (52) which is connected in series to the first (4) and second (8) electronic switch associated with the connection point (1').

6. Device for carrying out the method according to claim 2, having an adaptor device (2) in which test pins (2') can be used to establish electrical connections between contact elements (3') of the contact bank (3) and the connection points (1') of the conductors (1") of a circuit board (1) held in the device, a first electronic switch (4), by means of which an electrical connection can be established to a first potential, and a second electronic switch (8), by means of which an electrical connection can be established to a second potential ($V_{cc}$), being associated with each contact element (52), characterised in that the adaptor device (2) has a non-conducting mask (7) with has for each conductor (1") of the circuit board (1) one opening (7') through which, after alignment of the mask (7) relative to the circuit board (1), a test pin (2') can be passed to make contact with a connection point (1') of the conductor (1").

7. Device according to claim 6, characterised in that the mask (7) is in the form of a thin insulating sheet having openings (7').

8. Device according to claim 7, characterised in that the sheet is approximately 0.2 mm thick, given a potential spring excursion of the contact elements (3') of the grid bank (3) of 2–6 mm.

9. Device according to one of claims 6 to 8, characterised in that adjusting devices (50) are provided by means of which the mask (7) can be brought into alignment with the conductor (1) prior to carrying out the other processing steps.

10. Device for carrying out the method according to claim 3, having an adaptor device (21) in which electrical connections can be established between contact elements (30') of the contact bank (30) and the connection points (1') of the conductors (1") of a circuit board (1) held in the device, a first electronic switch (4), by means of which an electrical connection can be established to a first potential, and a second electronic switch (8), by means of which an electrical connection can be established to a second potential ($V_{cc}$), being associated with each contact element (30'), characterised in that the adaptor device (21) has shorter test pins (21') and longer test pins (21"), in that in each case a longer test pin (21") is disposed in such a way as to be associated with the one connection point (1') of a conductor (1") of the circuit board (1), and in that the difference in length between the short and long test pins (21', 21") is smaller than the potential spring excursion of the contact elements (30') of the contact bank (30) associated with the adaptor device (21).

11. Device according to claim 10, characterised in that the difference in length is in the region of approximately 2–3 mm, given a potential spring excursion of the contact elements (30') of around 4–8 mm.

12. Device for carrying out the method according to claim 4, having an adaptor device (20) in which electrical connections can be established between contact elements (3') of a contact bank (3) and the connection points (1') of the conductors (1") of a circuit board (1) held in the device, a first electronic switch (4), by means of which an electrical connection can be established to a first potential, and a second electronic switch (8), by means of which an electrical connection can be established to a second potential ($V_{cc}$), being associated with each contact element (3'), characterised in that the adaptor device (20) has spring test pins (20') with a shorter longitudinal spring excursion and spring test pins (20") with a longer longitudinal spring excursion, and in that in each case a test pin (20") having a longer spring excursion is disposed in such a way as to be associated with the one connection point (1') of a conductor (1") of the circuit board (1).

13. Device according to one of claims 9 to 12, characterised in that a shifting device (40) is provided by means of which the circuit board (1) can be moved by a predetermined distance longitudinally of the test pins (20', 20") while maintaining its position of alignment with the test pins (20', 20").

14. Device for carrying out the method according to claim 5, having an adaptor device (57) provided with test pins (51) which can be used to establish electrical connections between contact elements (52) of a contact bank (55) and the connection points (1') of the conductors (1") of a circuit board (1) held in the device, a first electronic switch (4), by means of which an electrical connection can be established to a first potential, and a second electronic switch (8), by means of which an electrical connection can be established by way of a current measuring element (6) to a second potential ($V_{cc}$), being associated with each contact element (52), characterised in that the device has, in front of the contact bank (55) an intermediate contact bank (53) fixed in a grid corresponding to the grid of the contact bank (55) and being provided at the individual grid points with through-holes (58) into which rigid contact elements (54) can be selectively inserted in order in each case to establish the electrical connections between one connection point (1') of a conductor (1 ") and the corresponding contact element (52) of the contact bank (55).

15. Device according to claim 14, characterised in that the intermediate contact bank is in the form of an insulating sheet (53) having through-holes (58) into which pin-like elements (54) serving as contact elements can be selectively inserted.

16. Device according to claim 15, characterised in that the pin-like elements (54) have shoulders (56) projecting beyond their periphery which serve as stops and terminate the insertion movement from one side of the sheet (53).

_Fig.1_

_Fig.2_

$$\underline{Fig.3}$$

_Fig.4a_

_Fig.4b_

_Fig.5a_

_Fig.5b_

_Fig.6_

_Fig.7_